# EUROPÄISCHE PATENTSCHRIFT

(11) **EP 0 590 167 B1**
(45) Veröffentlichungstag und Bekanntmachung des Hinweises auf die Patenterteilung: **09.07.1997**
(21) Anmeldenummer: 92116358.0
(22) Anmeldetag: 24.09.1992
(51) Int. Cl.: H03K 17/08

(54) **Leistungsschalter mit strombegrenzender Induktivität**
Power switches with current-limiting inductance
Commutateurs de puissance avec inductance de limitation de courant

(43) Veröffentlichungstag der Anmeldung: 06.04.1994
(73) Patentinhaber: SIEMENS AKTIENGESELLSCHAFT, 80333 München (DE)
(72) Erfinder: Zierhut, Hermann, Dipl.-Ing., W-8402 Neutraubling (DE)

(56) Entgegenhaltungen:
- WO-A-91/03104
- DE-A- 3 237 220
- US-A- 3 456 125
- US-A- 4 390 790

## Beschreibung

Die Erfindung bezieht sich auf einen Leistungsschalter, auch Leitungsschutzschalter, der mit zwei antiseriell zwischen Arbeitselektroden (5) und in der Strombahn des Leistungsschalters geschalteten FETs (10) arbeitet, deren Gates gemeinsam an den einen Anschluß einer Steuerspannung (2) gelegt sind, deren Innenwiderstand bei einer bestimmten Steuerspannung (2) und einer Arbeitsspannung (4) einen niedrigen Wert aufweist und deren Innenwiderstand mit steigender Arbeitsspannung an den Arbeitselektroden (5) sprunghaft ansteigt.

Ein gattungsgemäßer Leistungsschalter mit zwei antiseriell geschalteten FET-Transistoren ist aus dem Dokument US-PS,4,390,790 bekannt. Dabei können die FET-Transistoren bidirektional sein, so daß sowohl Gleich- als auch Wechselstrom geschaltet werden kann.

Aus DE-A-32 37 220 ist bekannt, an den Source-Anschluß eines in einem Leistungsschalter arbeitenden Halbleiter-FET, eine strombegrenzende Induktivität anzuordnen. Diese stellt im Normalbetrieb einen Kurzschluß dar und schützt den FET bei Überströmen, insbesondere Kurzschlußströmen.

Das Dokument WO-91/03104 offenbart einen Schaltkreis, in dem Teilinduktivitäten an die Source-Anschlüsse zweier FET-Transistoren geschaltet sind.

Der Erfindung liegt daher die Aufgabe zugrunde, einen Leistungsschalter der obengenannten Art, auch Leitungsschutzschalter, auf einfache und kostengünstige Weise so auszubilden, daß er ohne Überdimensionierung einem satten Kurzschluß mit hoher Stromanstiegsgeschwindigkeit standhält.

Die genannte Aufgabe wird durch einen Leistungsschalter nach Anspruch 1 oder 5 gelöst.

In die den Laststrom führende Strombahn des Leistungsschalters ist eine kleine Induktivität geschaltet, die im Normalbetrieb einen satten Kurzschluß darstellt. Hohe Stromanstiegsgeschwindigkeiten di/dt infolge von Kurzschlüssen führen zu einem großen Spannungsabfall an der Induktivität, der ohne zeitliche Verzögerung die (wirksame) Steuerspannung des Halbleiterschalters reduziert, und so dem Strom bis zum Einsatz der Regelung die gefährliche Spitze abschneidet. Für den normalen 50- oder 60-Hz-Strom stellt diese kleine Induktivität einen satten Kurzschluß dar. Sie hat auf den normalen Betrieb des Leistungsschalters keinen Einfluß.

Vorteilhafte Weiterbildungen der Erfindung sind den Unteransprüchen 2 bis 4 zu entnehmen.

Für einen Schalter, welcher für einen Nennstrom von 10 A bis 16 A ausgelegt ist, ist es vorteilhaft, wenn die Induktivität einen Wert von 10 bis 100 nH aufweist.

Weiterhin hat sich als vorteilhaft erwiesen, wenn die Induktivität als Reihenschaltung von mindestens zwei Teilinduktivitäten ausgeführt ist und wenn an jedem Source-Anschluß der FETs eine Teilinduktivität angeschlossen ist und der gemeinsame Verbindungspunkt der Teilinduktivitäten den negativen Anschlußpunkt für die Steuerspannung bildet.

Ist zu den Teilinduktivitäten jeweils eine Diode parallel geschaltet, wobei die Kathoden jeweils am Source-Anschluß der beiden FETs liegen, so ist hiermit ein einfacher Schutz der Gate-Source-Strecken gewährleistet. Bei umgekehrter Stromrichtung auftretende Steuerspannungs-Vergrößerungen werden verhindert, da die Dioden so geschaltet sind, daß die durch den Stromanstieg erzeugte Steuergegenspannung desjenigen FET, welcher inversen Strom führt, durch eine Diode überbrückt und damit unwirksam wird.

Es genügt die Verwendung nur einer Induktivität und nur einer Steuerspannung, wenn Mittel vorgesehen sind, mit denen der negative Anschlußpunkt der Steuerspannung abhängig von der Stromrichtung umschaltbar ist. Hierfür hat sich als zweckmäßig erwiesen, wenn als Mittel ein H-förmiges Netzwerk mit Dioden in den beiden parallelen Zweigen und mit einem ohmschen Widerstand in der Querverbindung vorgesehen ist, und wenn das Netzwerk parallel zur Induktivität geschaltet ist und dem ohmschen Widerstand der negative Anschlußpunkt der Steuerspannung zugeführt ist. Eine einfache und zugleich zweckmäßige Ausführung zeichnet sich dadurch aus, daß die Induktivität als Primärkreis-Induktivität eines Strom-/Spannungswandlers ausgeführt.

Die Erfindung wird im folgenden anhand verschiedener Ausführungsbeispiele näher erläutert. Es zeigen:
- FIG 1: einen Leistungsschalter mit in Reihe geschalteter Induktivität,
- FIG 2: einen Leistungsschalter mit antiseriell zu einem bipolaren Schalter zusammengeschalteten MOS-FETs und einer durch eine Induktivität bewirkte Stromanstiegsbegrenzung,
- FIG 3: einen Leistungsschalter nach FIG 2 mit Schutz der Teilinduktivitäten,
- FIG 4: einen Leistungsschalter nach FIG 3, bei dem die Teilinduktivitäten durch Stromwandler ersetzt sind,
- FIG 5: einen Leistungsschalter mit nur einer Induktivität und zwei Steuerspannungen,
- FIG 6: einen Leistungsschalter mit nur einer Induktivität und einer Steuerspannung,
- FIG 7: einen Leistungsschalter mit einem Stromwandler in ähnlicher Schaltung wie nach FIG 6.

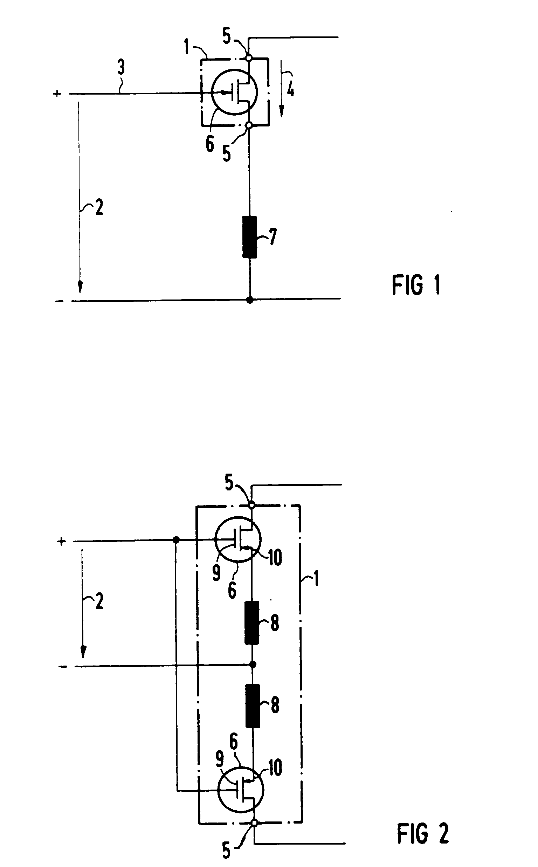

In FIG 1 ist ein Leistungsschalter mit einem FET 6 als Halbleiterelement 1 dargestellt, an den über eine Steuerelektrode 3 eine Steuerspannung 2 angelegt wird. Der Innenwiderstand des FETs 6 nimmt bei einer bestimmten Steuerspannung 2 und einer Arbeitsspannung 4 an in Durchlaßrichtung in einem Leitungszug liegenden Arbeitselektroden 5 einen niedrigen Wert an. In Serie zu der dem Lastkreis und dem Steuerkreis gemeinsamen Elektrode des Halbleiterschalters 1, der insbesondere als MOS-FET 6 ausgeführt ist, ist eine kleine Induktivität 7 geschaltet. Bei Stromanstieg infolge eines Kurzschlusses bzw. eines sonstigen ungewünschten Überstrom-Impulses wird an der Induktivität ein dem Induktionsgesetzt folgender Spannungsabfall u = L * di/dt erzeugt. Hierdurch wird zeitlich unverzögert die Steuerspannung des Halbleiterschalters 1 re-duziert und auf diese Weise dem Strom bis zum Einsatz einer Stromregelung die gefährliche Spitze abgeschnitten.

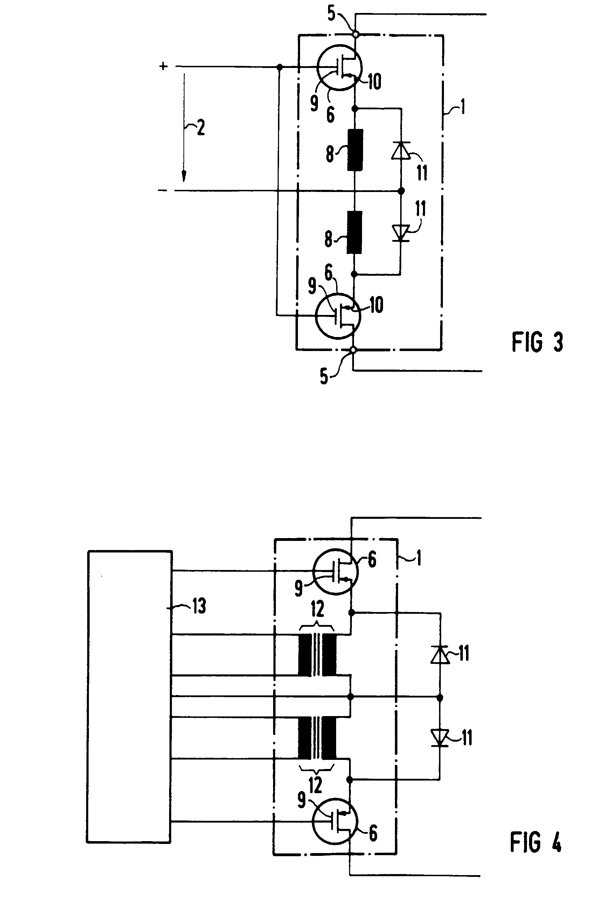

FIG 2 zeigt einen Leistungsschalter mit zwei antiseriell Zu einem bipolaren Schalter zusammengeschalteten MOS-FETs 6. Die strombegrenzende Induktivität besteht in dieser Schaltung aus zwei Teilinduktivitäten 8, die in Reihe geschaltet sind und jeweils mit einem Source-Anschluß 10 der beiden FETs 6 elektrisch verbunden sind. Der gemeinsame Verbindungspunkt der beiden Teilinduktivitäten 8 bildet den negativen Anschlußpunkt für die Steuerspannung 2. Zum Schutz der Gate-Source-Strecken der beiden FETs 6 kann zusätzlich noch je eine Diode 11 über jede Teilinduktivität 8 geschaltet werden (siehe FIG 3). Die Polarität bei der Schaltung der Dioden 11 ist dabei so festgelegt, daß ihre Kathoden an je einen Source-Anschluß 10 der FETs 6 zu liegen kommen, um die bei umgekehrter Stromrichtung auftretende Steuerspannungsvergrösserung zu verhindern. Die Dioden sind so geschaltet, daß die durch den Stromanstieg erzeugte Steuer-Gegenspannung desjenigen FETs 6, welcher inversen Strom führt, durch eine Diode 11 überbrückt und damit unwirksam wird. Der Leistungsschalter nach FIG 4 unterscheidet sich von dem in FIG 3 gestellten im wesentlichen dadurch, daß anstelle der Teilinduktivitäten 8 in der Schaltung Stromwandler 12 eingesetzt sind, wobei die Induktivitäten durch die Primärkreise der Stromwandler 12 gebildet werden. Die Sekundärkreise sind hier an eine Steuereinheit 13 geführt, die die erforderliche Steuerspannung liefert.

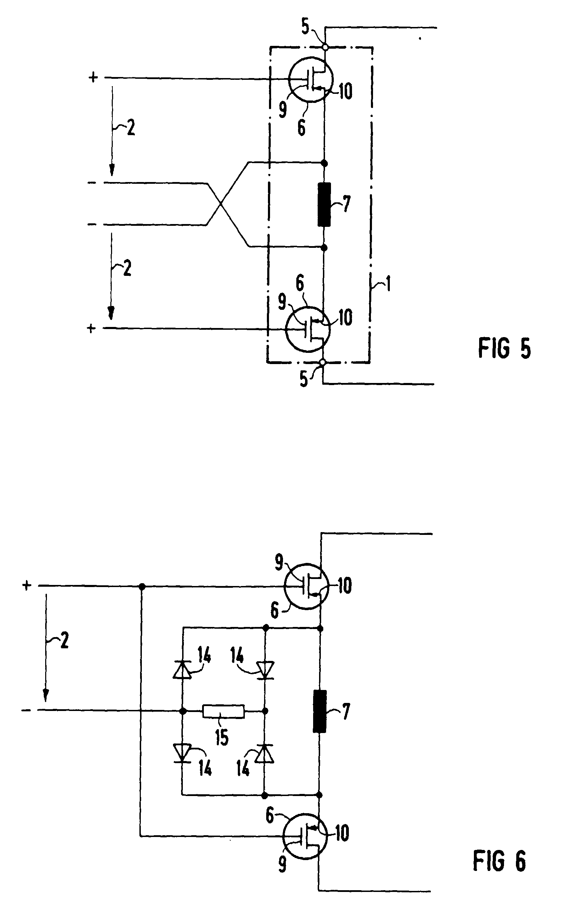

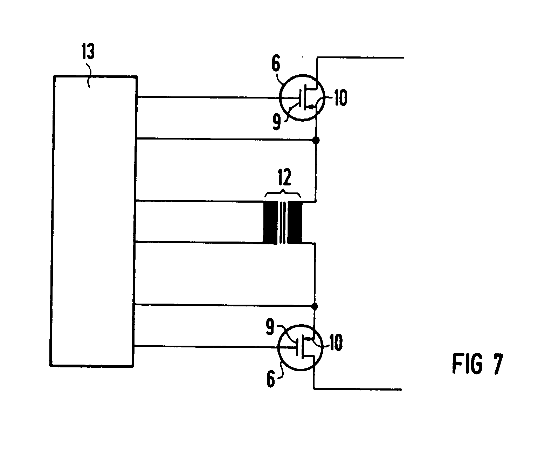

Die Ausführung des Leistungsschalters als bipolarer Schalter mit zwei MOS-FETs 6 ist aber auch in Verbindung mit nur einer Induktivität 7 möglich (siehe FIG 5). Die Induktivität 7 liegt hier zwischen den beiden Source-Anschlüssen 10 der beiden FETs 6. Allerdings ist bei dieser Ausführung die Versorgung mit zwei getrennten Steuerspannungen 2 erforderlich. Eine Abwandlung dieser Schaltung zeigt FIG 6, wo neben einer Induktivität 7 auch nur eine Steuerspannung 2 vorhanden ist. Parallel zur Induktivität 7 ist ein Netzwerk mit vier Dioden 14 geschaltet, von denen jeweils zwei in jedem Zweig antiseriell geschaltet sind und die in den Zweigen parallel zueinander liegenden Dioden antiparallel geschaltet sind. In der Querverbindung der beiden parallelen Zweige dieses Netzwerkes liegt ein ohmscher Widerstand 15, der an den negativen Anschlußpunkt für die Steuerspannung geführt 2 ist. Eine Abwandlung dieses Leistungsschalters mit einem Stromwandler 12 anstelle der Induktivität 7 zeigt FIG 7.

Durch den Einsatz einer Induktivität kann somit die Reaktionszeit der Kurzschlußstrombegrenzung durch elektronische Leistungs- bzw. Leitungsschutzschalter verkürzt werden.

## Patentansprüche

1. Leistungsschalter (1), auch Leitungsschutzschalter, der mit zwei antiseriell zwischen Arbeitselektroden (5) und in der Strombahn des Leistungsschalters geschalteten FETs (6) arbeitet, deren Gates gemeinsam an den einen Anschluß einer Steuerspannung (2) gelegt sind, deren Innenwiderstand bei einer bestimmten Steuerspannung (2) und einer Arbeitsspannung (4) einen niedrigen Wert aufweist und deren Innenwiderstand mit steigender Arbeitsspannung an den Arbeitselektroden (5) sprunghaft ansteigt, **dadurch gekennzeichnet**, daß die beiden Source-Anschlüsse (10) der FETs über eine Induktivität verbunden sind, die im Normalbetrieb einen satten Kurzschluß darstellt und daß die Induktivität aus der Primärwicklung von mindestens einem Stromwandler (12) besteht, dessen Primärkreis-Induktivität in Höhe der Induktivität bemessen ist, und dessen Sekundärkreis an einer Steuereinheit (13) angeschlossen ist, die die Steuerspannung (2) liefert.

2. Leistungsschalter nach Anspruch 1, **dadurch gekennzeichnet,** daß Mittel (14,15) vorgesehen sind, mit denen ein negativer Anschlußpunkt der Steuerspannung (2) abhängig von der Stromrichtung von dem einen der beiden FETs auf den anderen umschaltbar ist.

3. Leistungsschalter nach Anspruch 1, **dadurch gekennzeichnet,** daß die Induktivität (7) aus zwei Teilinduktivitäten (8) zusammengesetzt ist, zu denen jeweils eine zweier antiseriell geschalteter Dioden (11) parallel liegt, deren Kathoden an den Source-Anschlüssen (10) liegen.

4. Leistungsschalter nach Anspruch 2, **dadurch gekennzeichnet,** daß als Mittel ein H-förmiges Netzwerk mit Dioden (14) in den beiden parallelen Zweigen und mit einem ohmschen Widerstand (15) in der Querverbindung vorgesehen ist, welches parallel zur Induktivität (7) geschaltet ist und daß dem ohmschen Widerstand (15) der negative Anschlußpunkt der Steuerspannung (2) zugeführt ist.

5. Leistungsschalter (1), auch Leitungsschutzschalter, der mit zwei antiseriell zwischen Arbeitselektroden (5) und in der Strombahn des Leistungsschalters geschalteten FETs (6) arbeitet, deren Gates gemeinsam an den einen Anschluß einer Steuerspannung (2) gelegt sind, deren Innenwiderstand bei einer bestimmten Steuerspannung (2) und einer Arbeitsspannung (4) einen niedrigen Wert aufweist und deren Innenwiderstand mit steigender Arbeitsspannung an den Arbeitselektroden (5) sprunghaft ansteigt, **dadurch gekennzeichnet,** daß die beiden Source-Anschlüsse (10) der FETs über eine Induktivität (7) verbunden sind, die im Normalbetrieb einen satten Kurzschluß darstellt, daß ein H-förmiges Netzwerk mit Dioden (14) in den beiden parallelen Zweigen und mit einem ohmschen Widerstand (15) in der Querverbindung vorgesehen ist, welches parallel zu der Induktivität (7) geschaltet ist und daß dem ohmschen Widerstand (15) der negative Anschlußpunkt der Steuerspannung (2) zugeführt ist.

## Claims

1. Circuit-breaker (1), also line safety switch, which operates with two FETs (6) connected anti-serially between operating electrodes (5) and in the current-conducting path of the circuit-breaker, the gates of which FETs are jointly connected to the one a terminal of a control voltage (2), the internal resistance of which FETs has a low value at a certain control voltage (2) and an operating voltage (4), and the internal resistance of which FETs rises suddenly with rising operating voltage at the operating electrodes (5), characterised in that the two source terminals (10) of the FETs are connected via an inductance, which represents a dead short-circuit in normal operation, and in that the inductance consists of the primary winding of at least one current transformer (12), the primary-circuit inductance of which is dimensioned in the level of the inductance, and the secondary circuit of which is connected to a control unit (13), which supplies the control voltage (2).

2. Circuit-breaker according to claim 1, characterised in that there are provided means (14, 15) with which a negative terminal of the control voltage (2), depending on the current direction, can be switched over from one of the two FETs to the other.

3. Circuit-breaker according to claim 1, characterised in that the inductance (7) is made up of two partial inductances (8), in parallel with which is connected in each case one of two anti-serially connected diodes (11), the cathodes of which are connected to the source terminals (10).

4. Circuit-breaker according to claim 2, characterised in that there is provided as means an H-shaped network having diodes (14) in the two parallel branches and having an ohmic resistance (15) in the transverse connection, which network is connected in parallel with the inductance (7), and in that the negative terminal of the control voltage (2) is supplied to the ohmic resistance (15).

5. Circuit breaker (1), also line safety switch, which operates with two FETs (6) connected anti-serially between operating electrodes (5) and in the current-conducting path of the circuit-breaker, the gates of which FETs are jointly connected to the one terminal of a control voltage (2), the internal resistance of which FETs has a low value at a certain control voltage (2) and an operating voltage (4), and the internal resistance of which FETs rises suddenly with rising operating voltage at the operating electrodes (5), characterised in that the two source terminals (10) of the FETs are connected via an inductance (7), which represents a dead short-circuit in normal operation, in that there is provided an H-shaped network having diodes (14) in the two parallel branches and having an ohmic resistance (15) in the transverse connection, which network is connected in parallel with the inductance (7), and in that the negative terminal of the control voltage (2) is supplied to the ohmic resistance (15).

## Revendications

1. Disjoncteur (1) de puissance, également disjoncteur de protection de ligne, qui fonctionne avec deux transistors (6) à effet de champ, qui sont branchés de manière antisérielle entre des électrodes (5) de travail et dans le circuit du courant du disjoncteur de puissance, dont les grilles sont reliées en commun à l'une des bornes d'une tension (2) de commande, dont la résistance interne a une valeur basse pour une certaine tension (2) de commande et une tension (4) de travail et dont la résistance interne croît par sauts lorsque la tension de travail aux bornes des électrodes (5) de travail croît, caractérisé en ce que les deux bornes (10) de source des transistors à effet de champ sont reliées par l'intermédiaire d'une inductance, qui représente en fonctionnement normal un court-circuit à fond et l'inductance est constituée de l'enroulement primaire d'au moins un transformateur (12) de courant, dont l'inductance de circuit primaire a une valeur de l'ordre de l'inductance et dont le circuit secondaire est connecté à une unité (13) de commande qui fournit la tension (2) de commande.

2. Disjoncteur de puissance selon la revendication 1, caractérisé en ce qu'il est prévu des moyens (14, 15), par lesquels un point de connexion négatif de la tension (2) de commande peut être commuté, en fonction du sens du courant de l'un des deux transistors à effet de champ sur l'autre transistor à effet de champ.

3. Disjoncteur de puissance selon la revendication 1, caractérisé en ce que l'inductance (7) est constituée de deux inductances partielles (8), en parallèle avec chacune desquelles se trouve l'une parmi deux diodes (11) branchées de manière antisérielle, les cathodes de ces diodes étant reliées aux bornes (10) de source.

4. Disjoncteur de puissance suivant la revendication 2, caractérisé en ce qu'il est prévu comme moyen un réseau en H comportant des diodes (14) dans les deux branches parallèles et une résistance ohmique (15) dans la liaison transversale, le réseau étant branché en parallèle avec l'inductance (7) et le point de connexion négatif de la tension (2) de commande est appliqué à la résistance ohmique (15).

5. Disjoncteur de puissance (1), également disjoncteur de protection de ligne, qui fonctionne avec deux transistors (6) à effet de champ, qui sont branchés de manière antisérielle entre des électrodes (5) de travail et dans le circuit du courant du disjoncteur de puissance, dont les grilles sont reliées en commun à l'une des bornes d'une tension (2) de commande, dont la résistance interne a une valeur basse pour une tension (2) prescrite de commande et une tension (4) de travail et dont la résistance interne augmente par sauts lorsque la tension de travail aux bornes des électrodes (5) de travail croît, caractérisé en ce que les deux bornes (10) de source des transistors à effet de champ sont reliées par l'intermédiaire d'une inductance (7), qui représente en fonctionnement normal un court-circuit à fond, il est prévu un réseau en H comportant des diodes (14) dans les deux branches parallèles et une résistance ohmique (15) dans la liaison transversale, le réseau étant branché en parallèle avec l'inductance (7) et le point de connexion négatif de la tension (2) de commande étant appliqué à la résistance ohmique (15).
